# EUROPEAN PATENT SPECIFICATION

(11) **EP 3 163 748 B1**
(45) Date of publication and mention of the grant of the patent: **24.06.2020**
(21) Application number: 16193592.9
(22) Date of filing: 12.10.2016
(51) Int. Cl.: H03G 3/32

(54) **METHOD, DEVICE AND TERMINAL FOR ADJUSTING VOLUME**
VERFAHREN, VORRICHTUNG UND ENDGERÄT ZUR ANPASSUNG DER LAUTSTÄRKE
PROCÉDÉ, DISPOSITIF ET TERMINAL DE RÉGLAGE DU VOLUME

(30) Priority: 29.10.2015 CN 201510717388
(43) Date of publication of application: 03.05.2017
(73) Proprietor: Xiaomi Inc., Beijing 100085 (CN)
(72) Inventor: FU, Qiang, Haidian District, Beijing 100085 (CN); ZHOU, Shiquan, Haidian District, Beijing 100085 (CN); HOU, Enxing, Haidian District, Beijing 100085 (CN)
(74) Representative: Loustalan, Paul William

(56) References cited:
- EP-B1- 1 210 767
- WO-A2-01/39370
- US-A1- 2005 059 369
- US-A1- 2009 226 009
- US-B1- 6 584 201

## Description

### FIELD

The present disclosure generally relates to the field of communication technology, and more particularly to a method, device and terminal for adjusting volume.

### BACKGROUND

With rapid development of terminal technology, there are more and more playback devices such as radio, Bluetooth loudspeaker boxes, and the like. When using a playback device, users always need to adjust volume manually if ambient noise changes, bringing inconvenience to the user.

EP1210767B1 describes a method and apparatus for automatically adjusting microphone and speaker gains within a mobile telephone. US2009226009A1 describes a mechanism for adjusting the sound level of a portable electronic device. WO0139370A2 describes a partitioned signal processing system and methods for controlling signals, especially audio signals, within a varying environment. US2005059369A1 describes a method and apparatus for maintaining audio level preferences in a communication device. US 6 584 201 B1 describes a method for adjusting volume according to the preamble of claim 1.

### SUMMARY

The invention is defined by the independent claims to which reference is now made. Advantageous features of the invention are set out in the dependent claims.

According to a first aspect of the present disclosure, there is provided a method for adjusting volume, comprising: on a control device, acquiring noise information on ambient noise during playback of audio on a playback device; and on the control device, adjusting the volume of the audio on the playback device based on the noise information, comprising: acquiring amplitude of the ambient noise from the noise information; acquiring a volume adjustment parameter corresponding to the amplitude of the ambient noise, wherein the volume adjustment parameter is a predetermined volume adjustment value or a predetermined volume adjustment ration; generating a control instruction for adjusting volume of the audio based on the noise information, sending the control instruction to the playback device to trigger the playback device to adjust volume of the audio based on the noise information, and wherein the control instruction comprises instructions to: turn down the volume of the audio based on the volume adjustment parameter when the amplitude of the ambient noise is below or equal to a second predetermined threshold for a period exceeding a predetermined value; turn up the volume of the audio based on the volume adjustment parameter when the amplitude of the ambient noise is above or equal to a first predetermined threshold for a period exceeding a predetermined value; the method further comprising: recording an original volume of the audio, wherein the original volume is a volume set by a user before adjusting volume of the audio based on the noise information; and after turning up the volume of the audio based on the volume adjustment parameter, turn down the volume of the audio to the original volume of the audio, when the amplitude of the ambient noise is detected to decrease.

Alternatively, the noise information may be detected by a built-in noise capture sensor, or received from a noise capture device.

According to a second aspect of the present disclosure, there is provided a system comprising a control device for adjusting volume and a playback device, the control device comprising: an information acquiring unit configured to acquire noise information including amplitude of ambient noise during playback of audio on a playback device; and an adjustment unit configured to adjust volume of the audio on the playback device based on the noise information, wherein the adjustment unit is configured to: acquire amplitude of the ambient noise from the noise information; acquire a volume adjustment parameter corresponding to the amplitude of the ambient noise; generate a control instruction for adjusting volume of the audio based on the noise information and send the control instruction to a playback device to trigger the playback device to adjust volume of the audio based on the noise information, wherein the adjustment unit is configured to: generate and send a control instruction to turn down the volume of the audio based on the volume adjustment parameter when the amplitude of the ambient noise is below or equal to a second predetermined threshold for a period exceeding a predetermined value; generate and send a control instruction to turn up the volume of the audio based on the volume adjustment parameter when the amplitude of the ambient noise is above or equal to a first predetermined threshold for a period exceeding a predetermined value; the system comprising means configured to record an original volume of the audio, wherein the original volume is a volume set by a user before adjusting volume of the audio based on the noise information; and means configured to, after turning up the volume of the audio based on the volume adjustment parameter, generate and send a control instruction to decrease the volume of the audio to the original volume of the audio, when the amplitude of the ambient noise is detected to decrease.

Alternatively, the information acquiring unit may include: a detection sub-unit configured to detect the noise information by a built-in noise capture sensor; or a receiving sub-unit configured to receive the noise information sent by a noise capture device. By acquiring noise information on ambient noise, volume of the audio may be adjusted based on the noise information. By reflecting the condition of current ambient noise through the noise information, volume of the audio may be adjusted based on the noise information without adjusting volume manually by a user, bringing convenience to the user.

In the present disclosure, the noise information may be detected by a built-in noise capture sensor, or received from a noise capture device. The above manners may be easy to implement, and accuracy of the captured noise information is higher.

Where functional modules are referred to in apparatus examples for carrying out various steps of the described method(s) it will be understood that these modules may be implemented in hardware, in software, or a combination of the two. When implemented in hardware, the modules may be implemented as one or more hardware modules, such as one or more application specific integrated circuits. When implemented in software, the modules may be implemented as one or more computer programs that are executed on one or more processors.

### BRIEF DESCRIPTION OF THE DRAWINGS

The accompanying drawings, which are incorporated in and constitute a part of this specification, illustrate examples of this disclosure, together with the description, serve to explain the principles of the invention.
Fig. 1 is a flow chart illustrating a method for adjusting volume according to an example.
Fig. 2 is a flow chart illustrating another method for adjusting volume according to an example.
Fig. 3 is a flow chart illustrating another method for adjusting volume according to an example.
Fig. 4 is a flow chart illustrating another method for adjusting volume according to an example.
Fig. 5 is a schematic diagram illustrating a scenario for applying a method for adjusting volume according to an example.
Fig. 6 is a block diagram illustrating a device for adjusting volume according to an example.
Figs. 7-12 are block diagrams illustrating another device for adjusting volume according to an example.
Fig. 13 is a block diagram illustrating a device for adjusting volume according to an example.

### DETAILED DESCRIPTION

Reference will now be made in detail to examples, of which are illustrated in the accompanying drawings. The following description refers to the accompanying drawings in which same numbers in different drawings represent same or similar elements unless otherwise described. The implementations set forth in the following description of examples do not represent implementations consistent with the invention. Instead, they are merely examples of device and methods explaining aspects related to the invention as recited in the appended claims.

The terms used in the present disclosure are merely for describing particular examples rather than limiting the present disclosure. Terms, such as "a", "an", "said", and "the", as used in singular form in the present disclosure and appended claims may include plural form, unless otherwise described. It also should be understood that the term "and/or" used herein may refer to and include any or all of possible combinations of one or more associated items which have been listed.

It should be understood that the terms "first," "second," and "third," may be used to describe various information, but these information are not limited to these terms. These terms may only used to separate the same type of the information from each other. For example, the first information may also be referred as the second information without departing from the scope of the present disclosure. Similarly, the second information may also be referred as the first information. The word "if' as used herein may be interpreted as "when" or "while" or "respond to determination" depending on the context.

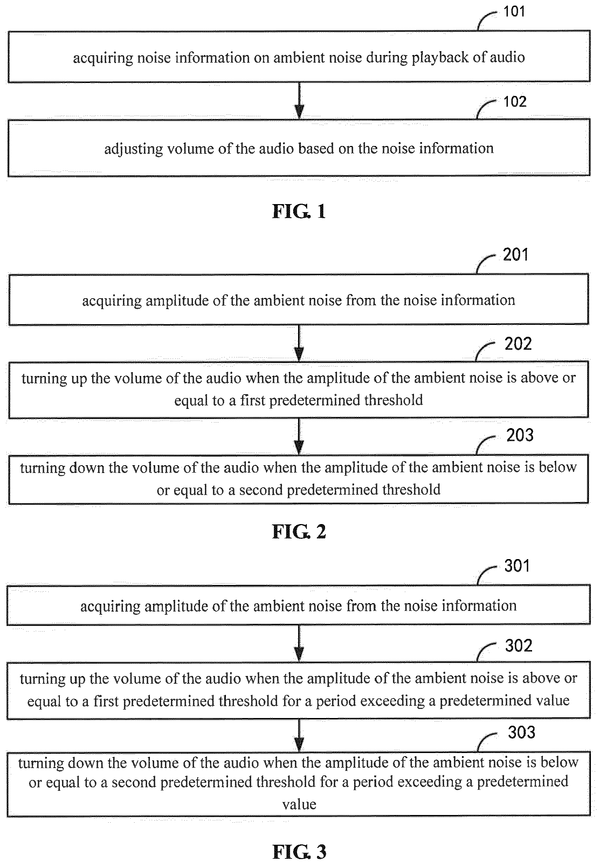

As shown in Fig.1, Fig. 1 is a flow chart illustrating a method for adjusting volume according to an example. The method may include the following steps 101-102.

In step 101, noise information on ambient noise may be acquired during playback of audio.

In step 102, volume of the audio may be adjusted based on the noise information.

In the examples of the present disclosure, by acquiring noise information on ambient noise, volume of the audio may be adjusted based on the noise information. By reflecting the condition of current ambient noise through the noise information, volume of the audio may be adjusted based on the noise information without adjusting volume manually by a user, bringing convenience to the user.

The examples of the present disclosure may be performed by a playback device for playing at least one of the information such as audio, video, animation and the like. The playback device may be for example computer, tablet computer, television, mobile phone, personal stereo, handheld reader and the like. The examples of the present disclosure may be performed by a control device for controlling the playback of a playback device. The playback device may have playback control function, and may have both playback control function and noise capture function. The control device may have noise capture function.

Wherein, with respect to step 101, ambient noise signal may generally be captured when capturing ambient noise around a terminal. The ambient noise signal may include various noise parameters, such as tone, volume and timbre and the like. In the examples of the present disclosure, noise information on ambient noise may refer to volume. The volume may be referred to loudness or the loudness of a sound, representing the strength of a sound, and its unit is "decibels (dB)". Playing audio may include any one of the manners in a terminal of outputting audio signal, such as outputting audio when a smart terminal is playing audio file or a smart terminal is playing video file, outputting audio when a mobile phone is communicating with other terminals via phone, outputting audio after receiving audio signal sent by a control device by a wireless speaker, or outputting audio after receiving radio wave by a smart radio and converting it into audio signal.

In an alternative implementation, the manners of acquiring noise information on ambient noise may include: detecting the noise information by a built-in noise capture sensor. The noise capture sensor may be built in an executing device of the examples of the present disclosure, namely the playback device or control device described above. The captured noise information may be directly amplitude of the ambient noise, or may detect amplitude of the ambient noise from the captured noise information.

In another alternative implementation, the manners of acquiring noise information on ambient noise may include: receiving the noise information sent by a noise capture device. The noise capture device may be set independently from the executing device of the examples of the present disclosure. The captured noise information may be directly amplitude of the ambient noise, or may detect amplitude of the ambient noise from the captured noise information.

With respect to step 102, correspondence relationship between different noise information on ambient noise and various volume adjustments may be preset. Volume adjustment corresponding to the noise information may be performed based on the preset correspondence relationship. The volume adjustment may refer to adjustment of common volume of audio output involved in audio, video or call and the like, for example, turning up the volume or turning down the volume. For example, the volume of the audio may be turned up when the ambient is detected to be noisy through noise information on ambient noise, or the volume of the audio may be turned down when the ambient noise is detected to decrease.

In an alternative implementation, adjusting volume of the audio based on the noise information may include: when the audio is played on the present, or first, terminal, adjusting directly volume of the audio based on the noise information; and when the audio is played on another, or second, terminal, generating a control instruction for adjusting volume of the audio based on the noise information, and sending the control instruction to the another terminal to trigger the another terminal to adjust volume of the audio based on the noise information.

In examples of the present disclosure, in one of the common application scenarios, the method for adjusting volume may be performed by a playback device. A playback device may adjust volume directly when the audio is played on the playback device. In another common application scenario, the method for adjusting volume may be performed by a control device for controlling the playback of the playback device. As the audio is played on a playback device, a control device may generate a control instruction and send it to the playback device to trigger the playback device to adjust volume accordingly. In other application scenarios, the method for adjusting volume may be performed by a control device for controlling the playback of the playback device. A control device may output audio and a playback device may also output audio. The control device may adjust directly volume of the audio which is played on current device based on the noise information, and at the same time may also generate a control instruction and send it to the playback device to trigger the playback device to adjust volume accordingly. In the manners described above, volume of the audio on the present terminal may be adjusted, and volume of the audio on another terminal may be adjusted too, improving flexibility and effectiveness of adjusting volume.

From the above examples, by acquiring noise information on ambient noise, volume of the audio may be adjusted based on the noise information. By reflecting the condition of current ambient noise through the noise information, volume of the audio may be adjusted based on the noise information without adjusting volume manually by a user, bringing convenience to the user.

As shown in Fig.2, Fig. 2 is a flow chart illustrating another method for adjusting volume according to an example. On the basis of the above examples shown in Fig. 1, the present examples describe a processing procedure on how to adjust volume of the audio based on the noise information. The procedure may include the following steps 201-203.

In step 201, amplitude of the ambient noise may be acquired from the noise information.

In step 202, the volume of the audio may be turned up when the amplitude of the ambient noise is above or equal to a first predetermined threshold.

In step 203, the volume of the audio may be turned down when the amplitude of the ambient noise is below or equal to a second predetermined threshold.

In examples of the present disclosure, amplitude of the ambient noise may be acquired from the noise information, and the condition of ambient noise may be determined based on the amplitude of the ambient noise. If the amplitude of the ambient noise is large, the ambient noise may be determined to be large, and if the amplitude of the ambient noise is low, the ambient noise may be determined to be low. Wherein, a first predetermined threshold and a second predetermined threshold may be values such as 50 dB, 60 dB and the like, those skilled in the art may configure the value of the threshold as desired, the present examples is not limited in the context. When the amplitude of the ambient noise is large and exceeds the first predetermined threshold, it means that the ambient is noisy, thus the current volume of the audio may be turned up automatically so as to improve the effect of playing audio. When the amplitude of the ambient noise changes from high to low, the current volume of the audio may be turned down automatically so as to improve the effect of playing audio. The manner may be easy to implement, and may improve efficiency of adjusting volume.

As shown in Fig.3, Fig. 3 is a flow chart illustrating another method for adjusting volume according to an example. On the basis of the above examples shown in Fig. 1, the present examples describe another processing procedure on how to adjust volume of the audio based on the noise information. The procedure may include the following steps 301-303.

In step 301, amplitude of the ambient noise may be acquired from the noise information.

In step 302, the volume of the audio may be turned up when the amplitude of the ambient noise is above or equal to a first predetermined threshold for a period exceeding a predetermined value.

In step 303, the volume of the audio may be turned down when the amplitude of the ambient noise is below or equal to a second predetermined threshold for a period exceeding a predetermined value.

In examples of the present disclosure, amplitude of the ambient noise may be acquired from the noise information, and the condition of ambient noise may be determined based on the amplitude of the ambient noise. If the amplitude of the ambient noise is large, the ambient noise may be determined to be large, and if the amplitude of the ambient noise is low, the ambient noise may be determined to be low. Wherein, a first predetermined threshold and a second predetermined threshold may be values such as 50 dB, 60 dB and the like, and the predetermined value of a period may be 5 seconds, 10 seconds and the like, those skilled in the art may configure the value of the threshold as desired, the present examples is not limited in the context. When the amplitude of the ambient noise is large and exceeds the first predetermined threshold for a period exceeding a predetermined value, it means that the ambient is noisy, thus the current volume of the audio may be turned up automatically so as to improve the effect of playing audio. When the amplitude of the ambient noise changes from high to low and is below the second predetermined threshold for a period exceeding a predetermined value, the current volume of the audio may be turned down automatically so as to improve the effect of playing audio. The manner may be easy to implement, and may improve efficiency of adjusting volume.

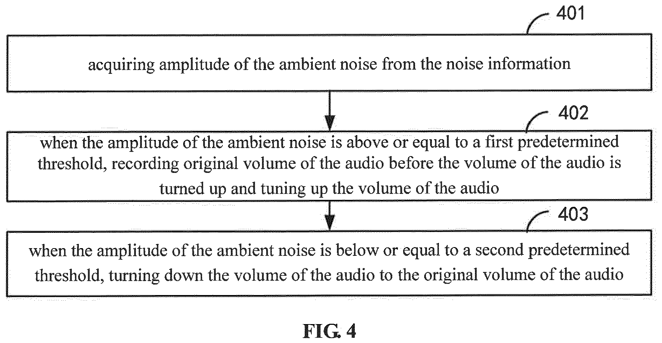

As shown in Fig.4, Fig. 4 is a flow chart illustrating another method for adjusting volume according to an example. On the basis of the above examples shown in Fig. 1, the present examples describe another processing procedure on how to adjust volume of the audio based on the noise information. The procedure may include the following steps 401-403.

In step 401, amplitude of the ambient noise may be acquired from the noise information.

In step 402, when the amplitude of the ambient noise is above or equal to a first predetermined threshold, original volume of the audio before the volume of the audio is turned up may be recorded and the volume of the audio may be turned up.

In step 403, when the amplitude of the ambient noise is below or equal to a second predetermined threshold, the volume of the audio may be turned down to the original volume of the audio.

In examples of the present disclosure, amplitude of the ambient noise may be acquired from the noise information, and the condition of ambient noise may be determined based on the amplitude of the ambient noise. If the amplitude of the ambient noise is large, the ambient noise may be determined to be large, and if the amplitude of the ambient noise is low, the ambient noise may be determined to be low. Wherein, a first predetermined threshold and a second predetermined threshold may be values such as 50 dB, 60 dB and the like, those skilled in the art may configure the value of the threshold as desired, the present examples is not limited in the context. The original volume may refer to a volume set by a user before adjusting volume of the audio based on the amplitude of the ambient noise. After turning up the volume of the audio based on the amplitude of the ambient noise, the volume of the audio may be turned down to the original volume of the audio if the amplitude of the ambient noise is detected to decrease, so as to make the volume of the audio recover to a volume set by a user. The above manner may make the volume adjustment more flexible, improving the effect of adjusting volume.

In other alternative implementations, adjusting volume of the audio based on the noise information may include: acquiring amplitude of the ambient noise from the noise information; acquiring a volume adjustment parameter corresponding to the amplitude of the ambient noise; and adjusting the volume of the audio based on the volume adjustment parameter.

In examples of the present disclosure, correspondence relationship between different amplitudes of the ambient noise on ambient noise and volume adjustment parameters may be preset. Since amplitudes of the ambient noise may correspond to different volume adjustment parameters, more precise adjustment may be made when turning up volume of an audio, so as to improve the effect of playing audio. Wherein, the volume adjustment parameter may be a specific volume adjustment value, for example increase/decrease 10 dB, increase/decrease 20 dB and the like, or may be a volume adjustment ratio, for example increase/decrease 5%, increase/decrease 10% and the like. For example, when the amplitude of the ambient noise may range from 80 dB to 90 dB, corresponding volume adjustment parameter may be to make the volume increase 10 dB or increase 5%; or when the amplitude of the ambient noise may range from 30 dB to 40 dB, corresponding volume adjustment parameter may be to make the volume decrease 10 dB or decrease 5% and the like. In practice, those skilled in the art may configure the volume adjustment parameter flexibly, and may configure correspondence relationship between different amplitudes of the ambient noise on ambient noise and volume adjustment parameters flexibly, the present examples is not limited in the context.

From the above examples, by acquiring a volume adjustment parameter corresponding to the amplitude of the ambient noise, the volume of the audio may be adjusted based on the volume adjustment parameter. The above manner may improve accuracy and effectiveness of adjusting volume, improving the effect of playing audio.

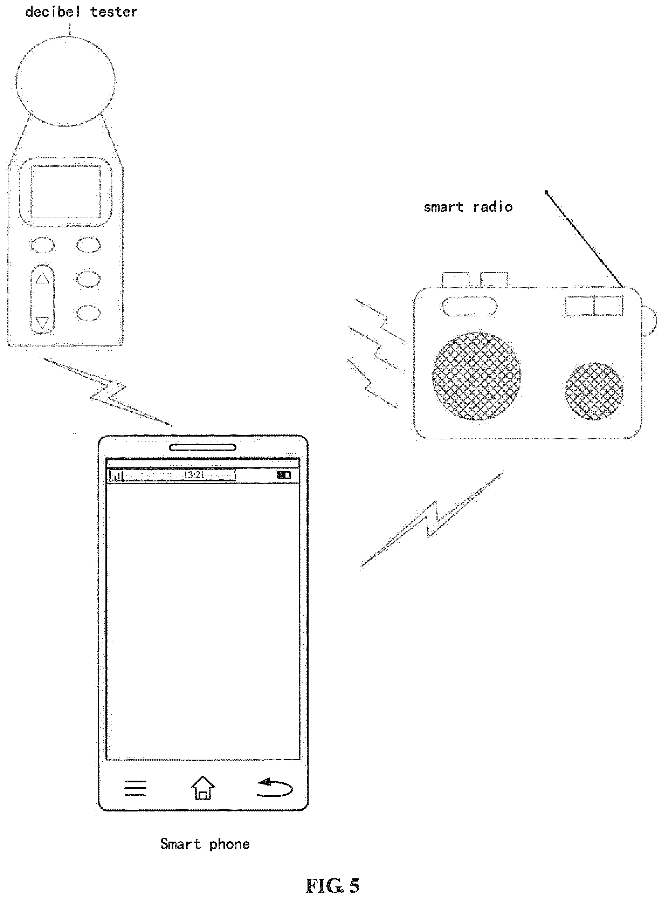

As shown in Fig. 5, Fig. 5 is a schematic diagram illustrating a scenario for applying a method for adjusting volume according to another example. In the scenario shown in Fig. 5, the scenario may include a decibel tester as a noise capture device, a smart phone as a control device, and a smart radio as a playback device. The decibel tester may be in wireless connection with the smart phone, and information transmission and interaction may be made between the decibel tester and the smart phone based on the wireless connection. The smart phone may be in wireless connection with the radio, and information transmission and interaction may be made between the smart phone and the radio based on the wireless connection. It is understood that the decibel tester is only an example to illustrate the noise capture device of the present examples, the smart phone is only an example to illustrate the control device, and the smart radio is only an example to illustrate the playing device. In practice, the noise capture device may also be other terminals such as microphone, the playing device may be other digital broadcasting terminals such as Bluetooth loudspeaker box or DVD, and the control device may also be other smart terminals such as Personal Computer (PC).

In the scenario shown in Fig. 5, the decibel tester may detect amplitude of the ambient noise and send the detected amplitude of the ambient noise to the smart phone shown in Fig. 5. When the detected amplitude of the ambient noise is large, the smart phone may generate a corresponding control instruction for turning up the volume based on the amplitude of the ambient noise and send the control instruction to the smart radio. The smart radio may turn up the volume based on the noise information on ambient noise accordingly.

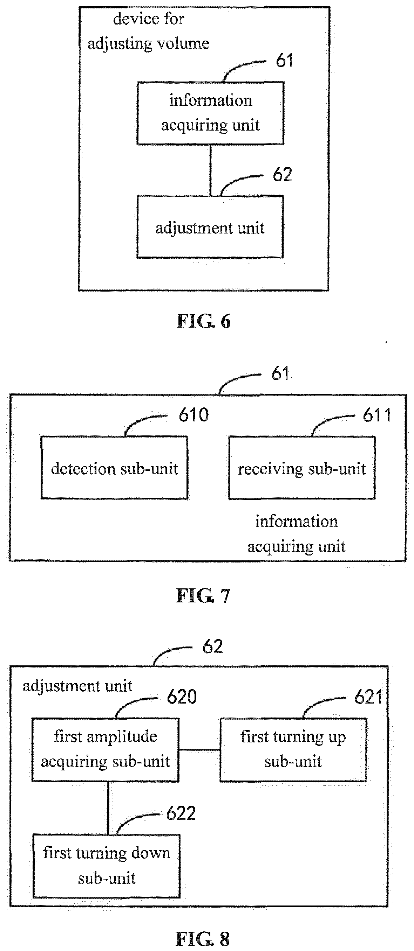

As shown in Fig. 6, Fig. 6 is a block diagram illustrating a device for adjusting volume according to an example. The device for adjusting volume may include: an information acquiring unit 61 and an adjustment unit 62. Wherein, the information acquiring unit 61 may be configured to acquire noise information on ambient noise during playback of audio. The adjustment unit 62 may be configured to adjust volume of the audio based on the noise information.

In examples of the present disclosure, by acquiring noise information on ambient noise, volume of the audio may be adjusted based on the noise information. By reflecting the condition of current ambient noise through the noise information, volume of the audio may be adjusted based on the noise information without adjusting volume manually by a user, bringing convenience to the user.

As shown in Fig. 7, Fig. 7 is a block diagram illustrating another device for adjusting volume according to an example. On the basis of the above examples shown in Fig. 6, the information acquiring unit 61 may include: a detection sub-unit 610 or a receiving sub-unit 611. For convenience, the above two sub-units are show in Fig. 7 at the same time. Wherein, the detection sub-unit 610 may be configured to detect the noise information by a built-in noise capture sensor. A receiving sub-unit 611 may be configured to receive the noise information sent by a noise capture device.

In examples of the present disclosure, the noise information may be detected by a built-in noise capture sensor, or received from a noise capture device. The above manners may be easy to implement, and accuracy of the captured noise information is higher.

As shown in Fig. 8, Fig. 8 is a block diagram illustrating another device for adjusting volume according to an example. On the basis of the above examples shown in Fig. 6, the adjustment unit 62 may include: a first amplitude acquiring sub-unit 620, a first turning up sub-unit 621, and a first turning down sub-unit 622. Wherein, the first amplitude acquiring sub-unit 620 may be configured to acquire amplitude of the ambient noise from the noise information. The first turning up sub-unit 621 may be configured to turn up the volume of the audio when the amplitude of the ambient noise is above or equal to a first predetermined threshold. The first turning down sub-unit 622 may be configured to turn down the volume of the audio when the amplitude of the ambient noise is below or equal to a second predetermined threshold.

In examples of the present disclosure, by acquiring amplitude of the ambient noise from the noise information, the manner of adjusting volume may be determined based on a comparison of the amplitude of the ambient noise with a first predetermined threshold or a second predetermined threshold. The above manner may be easy to implement, and may improve efficiency of adjusting volume.

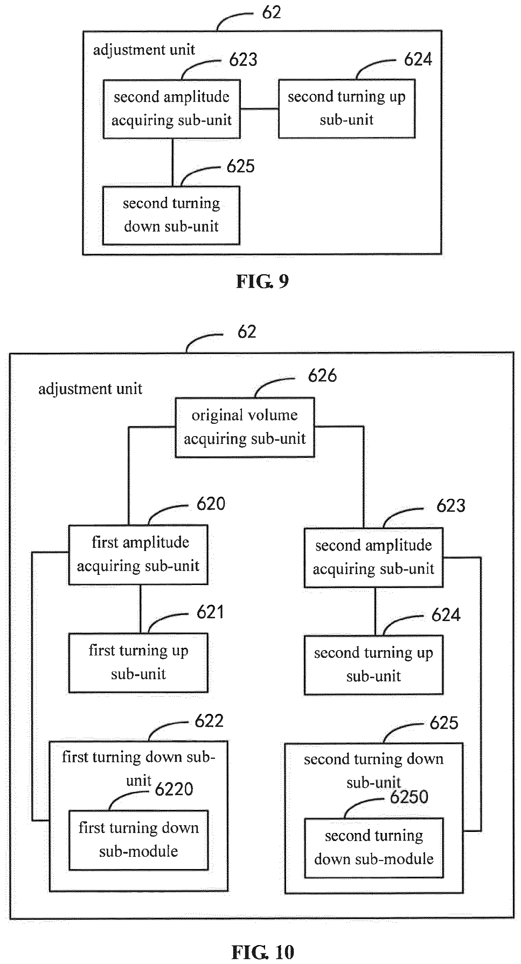

As shown in Fig. 9, Fig. 9 is a block diagram illustrating another device for adjusting volume according to an example. On the basis of the above examples shown in Fig. 6, the adjustment unit 62 may include: a second amplitude acquiring sub-unit 623, a second turning up sub-unit 624, and a second turning down sub-unit 625. Wherein, the second amplitude acquiring sub-unit 623 may be configured to acquire amplitude of the ambient noise from the noise information. The second turning up sub-unit 624 may be configured to turn up the volume of the audio when the amplitude of the ambient noise is above or equal to a first predetermined threshold for a period exceeding a predetermined value. The second turning down sub-unit 625 may be configured to turn down the volume of the audio when the amplitude of the ambient noise is below or equal to a second predetermined threshold for a period exceeding a predetermined value.

In examples of the present disclosure, by acquiring amplitude of the ambient noise from the noise information, the volume of the audio may be turned up when the amplitude of the ambient noise exceeds a first predetermined threshold for a period exceeding a predetermined value, and the volume of the audio may be turned down when the amplitude of the ambient noise is below a second predetermined threshold for a period exceeding a predetermined value. The above manners may be easy to implement, and may improve efficiency of adjusting volume.

As shown in Fig. 10, Fig. 10 is a block diagram illustrating another device for adjusting volume according to an example. On the basis of the above examples shown in Fig. 8 and Fig. 9, the adjustment unit 62 may further include: an original volume acquiring sub-unit 626 configured to record original volume of the audio before the volume of the audio is turned up before turning up the volume of the audio. Wherein, the first turning down sub-unit 622 may include a first turning down sub-module 6220 configured to turn down the volume of the audio to the original volume of the audio. The second turning down sub-unit 625 may include a second turning down sub-module 6250 configured to turn down the volume of the audio to the original volume of the audio.

In examples of the present disclosure, after turning up the volume of the audio based on the amplitude of the ambient noise, the volume of the audio may be turned down to the original volume of the audio if the amplitude of the ambient noise is detected to decrease, so as to make the volume of the audio recover to a volume set by a user. The above manners may make the volume adjustment more flexible, improving the effect of adjusting volume.

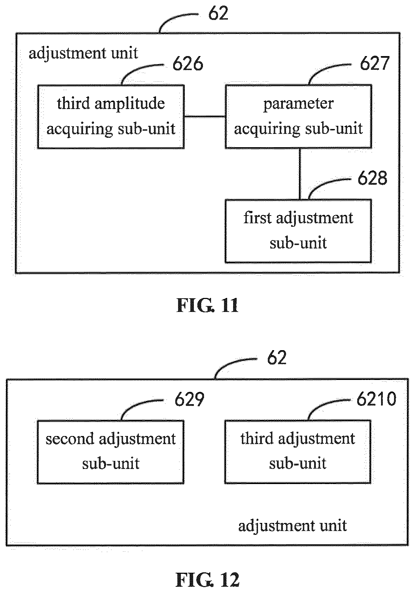

As shown in Fig. 11, Fig. 11 is a block diagram illustrating another device for adjusting volume according to an example. On the basis of the above examples shown in Fig. 6, the adjustment unit 62 may include: a third amplitude acquiring sub-unit 626, a parameter acquiring sub-unit 627, and a first adjustment sub-unit 628. Wherein, the third amplitude acquiring sub-unit 626 may be configured to acquire amplitude of the ambient noise from the noise information. The parameter acquiring sub-unit 627 may be configured to acquire a volume adjustment parameter corresponding to the amplitude of the ambient noise. The first adjustment sub-unit 628 may be configured to adjust the volume of the audio based on the volume adjustment parameter.

In examples of the present disclosure, by acquiring a volume adjustment parameter corresponding to the amplitude of the ambient noise, the volume of the audio may be adjusted based on the volume adjustment parameter, improving accuracy and effectiveness of adjusting volume and improving the effect of playing audio.

As shown in Fig. 12, Fig. 12 is a block diagram illustrating another device for adjusting volume according to an example. On the basis of the above examples shown in Fig. 6, the adjustment unit 62 may include: a second adjustment sub-unit 629 or a third adjustment sub-unit 6210. For convenience, the above two sub-units are show in Fig. 12 at the same time. Wherein, the second adjustment sub-unit 629 may be configured to adjust directly volume of the audio based on the noise information when the audio is played on the present terminal. Third adjustment sub-unit 6210 may be configured to generate a control instruction for adjusting volume of the audio based on the noise information and send the control instruction to the another terminal to trigger the another terminal to adjust volume of the audio based on the noise information when the audio is played on another terminal.

In examples of the present disclosure, volume of the audio on the present terminal may be adjusted, and volume of the audio on another terminal may be adjusted too, improving flexibility and effectiveness of adjusting volume.

Accordingly, a terminal is provided in the present disclosure, the terminal may include: a processor and a memory for storing processor-executable instructions, wherein the processor is configured to: acquire noise information on ambient noise during playback of audio; and adjust volume of the audio based on the noise information.

The process of implementing the functions of respective modules in the above device may refer to that of implementing the corresponding steps in the above method, which will not be elaborated herein.

For examples of the device, since they correspond to examples of the method, reference can be made to the description in examples of the method. The examples of the device described above are only illustrative. The unit described as a separate component may be or may not be separate physically. The component shown as a unit may be or may not be a physical unit, namely, the component may be located in a place or may be distributed over a plurality of network units. Part or all of the modules can be selected according to actual demand, so as to achieve the goal of the solutions of the present disclosure. An ordinary skilled person in the art can appreciate and practice the examples without creative work.

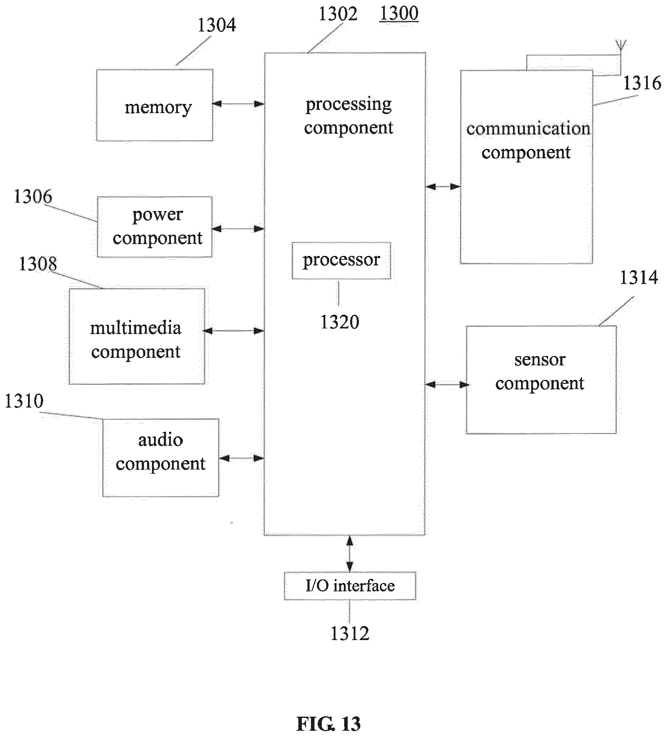

As shown in Fig. 13, Fig. 13 is a block diagram of an device 1300 for uninstalling an application according to an example. For example, the device 1300 may be a mobile phone having routing function, a computer, a digital broadcast terminal, a messaging device, a gaming console, a tablet, a medical device, an exercise equipment, a personal digital assistant, and the like.

Referring to Fig. 13, the device 1300 may include one or more of the following components: a processing component 1302, a memory 1304, a power component 1306, a multimedia component 1308, an audio component 1310, an input/output (I/O) interface 1312, a sensor component 1314, and a communication component 1316.

The processing component 1302 typically controls overall operations of the device 1300, such as the operations associated with display, telephone calls, data communications, camera operations, and recording operations. The processing component 1302 may include one or more processors 1320 to execute instructions to perform all or part of the steps in the above described methods. Moreover, the processing component 1302 may include one or more modules which facilitate the interaction between the processing component 1302 and other components. For instance, the processing component 1302 may include a multimedia module to facilitate the interaction between the multimedia component 1308 and the processing component 1302.

The memory 1304 is configured to store various types of data to support the operation of the device 1300. Examples of such data include instructions for any applications or methods operated on the device 1300, contact data, phonebook data, messages, pictures, video, etc. The memory 1304 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1306 provides power to various components of the device 1300. The power component 1306 may include a power management system, one or more power sources, and any other components associated with the generation, management, and distribution of power for the device 1300.

The multimedia component 1308 includes a screen providing an output interface between the device 1300 and the user. In some examples, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some examples, the multimedia component 1308 includes a front camera and/or a rear camera. The front camera and the rear camera may receive an external multimedia datum while the device 1300 is in an operation mode, such as a photographing mode or a video mode. Each of the front camera and the rear camera may be a fixed optical lens system or have optical focusing and zooming capability.

The audio component 1310 is configured to output and/or input audio signals. For example, the audio component 1310 includes a microphone ("MIC") configured to receive an external audio signal when the device 1300 is in an operation mode, such as a call mode, a recording mode, and a voice recognition mode. The received audio signal may be further stored in the memory 1304 or transmitted via the communication component 1316. In some examples, the audio component 1310 further includes a speaker to output audio signals.

The I/O interface 1312 provides an interface between the processing component 1302 and peripheral interface modules, the peripheral interface modules being, for example, a keyboard, a click wheel, buttons, and the like. The buttons may include, but are not limited to, a home button, a volume button, a starting button, and a locking button.

The sensor component 1314 includes one or more sensors to provide status assessments of various aspects of the device 1300. For instance, the sensor component 1314 may detect an open/closed status of the device 1300, relative positioning of components (e.g., the display and the keypad, of the device 1300), a change in position of the device 1300 or a component of the device 1300, a presence or absence of user contact with the device 1300, an orientation or an acceleration/deceleration of the device 1300, and a change in temperature of the device 1300. The sensor component 1314 may include a proximity sensor configured to detect the presence of a nearby object without any physical contact. The sensor component 1314 may also include a light sensor, such as a CMOS or CCD image sensor, for use in imaging applications. In some examples, the sensor component 1314 may also include an accelerometer sensor, a gyroscope sensor, a magnetic sensor, a pressure sensor, or a temperature sensor.

The communication component 1316 is configured to facilitate communication, wired or wirelessly, between the device 1300 and other devices. The device 1300 can access a wireless network based on a communication standard, such as WiFi, 2G, or 3G, or a combination thereof. In an example, the communication component 1316 receives a broadcast signal or broadcast associated information from an external broadcast management system via a broadcast channel. In an example, the communication component 1316 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In examples, the device 1300 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In examples, there is also provided a non-transitory computer-readable storage medium including instructions, such as included in the memory 1304, executable by the processor 1320 in the device 1300, for performing methods as described above. For example, the non-transitory computer-readable storage medium may be a ROM, a RAM, a CD-ROM, a magnetic tape, a floppy disc, an optical data storage device, and the like.

## Claims

1. A method for adjusting volume, comprising:
on a control device, acquiring (101) noise information on ambient noise, during playback of audio on a playback device; and
on the control device, adjusting (102) the volume of the audio on the playback device based on the noise information, comprising:
acquiring amplitude of the ambient noise from the noise information;
acquiring a volume adjustment parameter corresponding to the amplitude of the ambient noise, wherein the volume adjustment parameter is a predetermined volume adjustment value or a predetermined volume adjustment ratio;
generating a control instruction for adjusting the volume of the audio based on the noise information; and
sending the control instruction to the playback device to trigger the playback device to adjust the volume of the audio based on the noise information;
wherein the control instruction comprises instructions to:
turn down (303) the volume of the audio based on the volume adjustment parameter when the amplitude of the ambient noise is below or equal to a second predetermined threshold for a period exceeding a predetermined value;
turn up (302) the volume of the audio based on the volume adjustment parameter when the amplitude of the ambient noise is above or equal to a first predetermined threshold for a period exceeding a predetermined value;
the method **characterised by** comprising:
recording an original volume of the audio, wherein the original volume is a volume set by a user before adjusting volume of the audio based on the noise information; and
after turning up (302) the volume of the audio based on the volume adjustment parameter, turn down the volume of the audio to the original volume of the audio, when the amplitude of the ambient noise is detected to decrease.

2. The method of claim 1, wherein the noise information is detected by a built-in noise capture sensor, or received from a noise capture device.

3. A system comprising a control device for adjusting volume and a playback device, the control device comprising:
an information acquiring unit (61) configured to acquire noise information on ambient noise during playback of audio on a playback device; and
an adjustment unit (62) configured to adjust volume of the audio on the playback device based on the noise information; the adjustment unit being configured to:
acquire amplitude of the ambient noise from the noise information;
acquire a volume adjustment parameter corresponding to the amplitude of the ambient noise;
generate a control instruction for adjusting volume of the audio based on the noise information;
send the control instruction to the playback device to trigger the playback device to adjust volume of the audio based on the noise information;
whereby the adjustment unit is configured to:
generate and send a control instruction to turn down (303) the volume of the audio based on the volume adjustment parameter when the amplitude of the ambient noise is below or equal to a second predetermined threshold for a period exceeding a predetermined value;
generate and send a control instruction to turn up (302) the volume of the audio based on the volume adjustment parameter when the amplitude of the ambient noise is above or equal to a first predetermined threshold for a period exceeding a predetermined value;
**characterized in that** the system comprises:
means configured to record an original volume of the audio, wherein the original volume is a volume set by a user before adjusting volume of the audio based on the noise information; and
means configured to, after turning up (302) the volume of the audio based on the volume adjustment parameter, turn down the volume of the audio to the original volume of the audio, when the amplitude of the ambient noise is detected to decrease.

4. The system of claim 3, wherein the information acquiring unit (61) comprises:
a detection sub-unit (610) configured to detect the noise information by a built-in noise capture sensor; or
a receiving sub-unit (611) configured to receive the noise information sent by a noise capture device.

## Patentansprüche

1. Verfahren zur Anpassung der Lautstärke, umfassend:
an einer Steuervorrichtung Erfassen (101) von Geräuschinformationen über Umgebungsgeräusch während der Wiedergabe von Ton an einer Wiedergabevorrichtung; und
an der Steuervorrichtung Anpassen (102) der Lautstärke des Tons an der Wiedergabevorrichtung auf Basis der Geräuschinformationen, umfassend:
Erfassen der Amplitude des Umgebungsgeräuschs aus den Geräuschinformationen;
Erfassen eines Lautstärkeanpassungsparameters, der der Amplitude des Umgebungsgeräuschs entspricht, wobei der Lautstärkeanpassungsparameter ein vorbestimmter Lautstärkeanpassungswert oder ein vorbestimmtes Lautstärkeanpassungsverhältnis ist;
Erzeugen einer Steueranweisung zum Anpassen der Lautstärke des Tons auf Basis der Geräuschinformationen; und
Senden der Steueranweisung an die Wiedergabevorrichtung zum Ansteuern der Wiedergabevorrichtung zum Anpassen der Lautstärke des Tons auf Basis der Geräuschinformationen;
wobei die Steueranweisung Anweisungen aufweist zum:
Reduzieren (303) der Lautstärke des Tons auf Basis des Lautstärkeanpassungsparameters, wenn die Amplitude des Umgebungsgeräuschs für eine einen vorbestimmten Wert überschreitende Dauer unter oder gleich einem zweiten vorbestimmten Schwellenwert ist;
Erhöhen (302) der Lautstärke des Tons auf Basis des Lautstärkeanpassungsparameters, wenn die Amplitude des Umgebungsgeräuschs für eine einen vorbestimmten Wert überschreitende Dauer über oder gleich einem ersten vorbestimmten Schwellenwert ist;
wobei das Verfahren **dadurch gekennzeichnet ist, dass** es Folgendes umfasst:
Aufzeichnen einer ursprünglichen Lautstärke des Tons, wobei die ursprüngliche Lautstärke eine Lautstärke ist, die von einem Benutzer eingestellt wird, bevor die Lautstärke des Tons auf Basis der Geräuschinformationen angepasst wird; und
nach Erhöhen (302) der Lautstärke des Tons auf Basis des Lautstärkeanpassungsparameters Reduzieren der Lautstärke des Tons auf die ursprüngliche Lautstärke des Tons, wenn erkannt wird, dass die Amplitude des Umgebungsgeräuschs abnimmt.

2. Verfahren nach Anspruch 1, wobei die Geräuschinformationen durch einen eingebauten Geräuscherfassungssensor erkannt werden oder aus einer Geräuscherfassungsvorrichtung empfangen werden.

3. System, das eine Steuervorrichtung zur Anpassung der Lautstärke und eine Wiedergabevorrichtung umfasst, wobei die Steuervorrichtung Folgendes umfasst:
eine Informationserfassungseinheit (61), die zum Erfassen von Geräuschinformationen über Umgebungsgeräusch während der Wiedergabe von Ton an einer Wiedergabevorrichtung konfiguriert ist; und
eine Anpassungseinheit (62), die zum Anpassen der Lautstärke des Tons an der Wiedergabevorrichtung auf Basis der Geräuschinformationen konfiguriert ist, wobei die Anpassungseinheit konfiguriert ist zum:
Erfassen der Amplitude des Umgebungsgeräuschs aus den Geräuschinformationen;
Erfassen eines Lautstärkeanpassungsparameters, der der Amplitude des Umgebungsgeräuschs entspricht;
Erzeugen einer Steueranweisung zum Anpassen der Lautstärke des Tons auf Basis der Geräuschinformationen;
Senden der Steueranweisung an die Wiedergabevorrichtung zum Ansteuern der Wiedergabevorrichtung zum Anpassen der Lautstärke des Tons auf Basis der Geräuschinformationen;
so dass die Anpassungseinheit konfiguriert ist zum:
Erzeugen und Senden einer Steueranweisung zum Reduzieren (303) der Lautstärke des Tons auf Basis des Lautstärkeanpassungsparameters, wenn die Amplitude des Umgebungsgeräuschs für eine einen vorbestimmten Wert überschreitende Dauer unter oder gleich einem zweiten vorbestimmten Schwellenwert ist;
Erzeugen und Senden einer Steueranweisung zum Erhöhen (302) der Lautstärke des Tons auf Basis des Lautstärkeanpassungsparameters, wenn die Amplitude des Umgebungsgeräuschs für eine einen vorbestimmten Wert überschreitende Dauer über oder gleich einem ersten vorbestimmten Schwellenwert ist;
**dadurch gekennzeichnet ist, dass** das System Folgendes umfasst:
ein Mittel, das zum Aufzeichnen einer ursprünglichen Lautstärke des Tons konfiguriert ist, wobei die ursprüngliche Lautstärke eine Lautstärke ist, die von einem Benutzer eingestellt wird, bevor die Lautstärke des Tons auf Basis der Geräuschinformationen angepasst wird; und
ein Mittel, das, nach Erhöhen (302) der Lautstärke des Tons auf Basis des Lautstärkeanpassungsparameters, zum Reduzieren der Lautstärke des Tons auf die ursprüngliche Lautstärke des Tons, wenn erkannt wird, dass die Amplitude des Umgebungsgeräuschs abnimmt, konfiguriert ist.

4. System nach Anspruch 3, wobei die Informationserfassungseinheit (61) Folgendes umfasst:
eine Erkennungsuntereinheit (610), die zum Erkennen der Geräuschinformationen durch einen eingebauten Geräuscherfassungssensor konfiguriert ist; oder
eine Empfangsuntereinheit (611), die zum Empfangen der von einer Geräuscherfassungsvorrichtung gesendeten Geräuschinformationen konfiguriert ist.

## Revendications

1. Procédé de réglage de volume, comprenant :
sur un dispositif de commande, l'acquisition (101) d'informations de bruit relatives au bruit ambiant, durant une lecture audio sur un dispositif de lecture ; et
sur le dispositif de commande, le réglage (102) du volume de l'audio sur le dispositif de lecture sur la base des informations de bruit, comprenant :
l'acquisition d'une amplitude du bruit ambiant à partir des informations de bruit ;
l'acquisition d'un paramètre de réglage de volume correspondant à l'amplitude du bruit ambiant, le paramètre de réglage de volume étant une valeur de réglage de volume prédéterminée ou un rapport de réglage de volume prédéterminé ;
la génération d'une instruction de commande pour régler le volume de l'audio sur la base des informations de bruit ; et
l'envoi de l'instruction de commande au dispositif de lecture pour amener le dispositif de lecture à régler le volume de l'audio sur la base des informations de bruit ;
dans lequel l'instruction de commande comprend des instructions pour :
baisser (303) le volume de l'audio sur la base du paramètre de réglage de volume quand l'amplitude du bruit ambiant est inférieure ou égale à un second seuil prédéterminé pendant une période dépassant une valeur prédéterminée ;
augmenter (302) le volume de l'audio sur la base du paramètre de réglage de volume quand l'amplitude du bruit ambiant est supérieure ou égale à un premier seuil prédéterminé pendant une période dépassant une valeur prédéterminée ;
le procédé étant **caractérisé en ce qu'**il comprend :
l'enregistrement d'un volume original de l'audio, le volume original étant un volume réglé par un utilisateur avant le réglage du volume de l'audio sur la base des informations de bruit ; et
après l'augmentation (302) du volume de l'audio sur la base du paramètre de réglage de volume, la baisse du volume de l'audio au volume original de l'audio, quand il est détecté que l'amplitude du bruit ambiant a diminué.

2. Procédé selon la revendication 1, dans lequel les informations de bruit sont détectées par un capteur de bruit intégré, ou reçues d'un dispositif de capture de bruit.

3. Système comprenant un dispositif de commande pour régler un volume et un dispositif de lecture, le dispositif de commande comprenant :
une unité d'acquisition d'informations (61) configurée pour acquérir des informations de bruit relatives au bruit ambiant durant une lecture audio sur un dispositif de lecture ; et
une unité de réglage (62) configurée pour régler le volume de l'audio sur le dispositif de lecture sur la base des informations de bruit ; l'unité de réglage étant configurée pour :
acquérir une amplitude du bruit ambiant à partir des informations de bruit ;
acquérir un paramètre de réglage de volume correspondant à l'amplitude du bruit ambiant ;
générer une instruction de commande pour régler le volume de l'audio sur la base des informations de bruit ; et
envoyer l'instruction de commande au dispositif de lecture pour amener le dispositif de lecture à régler le volume audio sur la base des informations de bruit ;
dans lequel l'unité de réglage est configurée pour :
générer et envoyer une instruction de commande pour baisser (303) le volume de l'audio sur la base du paramètre de réglage de volume quand l'amplitude du bruit ambiant est inférieure ou égale à un second seuil prédéterminé pendant une période dépassant une valeur prédéterminée ;
générer et envoyer une instruction de commande pour augmenter (302) le volume de l'audio sur la base du paramètre de réglage de volume quand l'amplitude du bruit ambiant est supérieure ou égale à un premier seuil prédéterminé pendant une période dépassant une valeur prédéterminée ;
**caractérisé en ce que** le système comprend :
un moyen configuré pour enregistrer un volume original de l'audio, le volume original étant un volume réglé par un utilisateur avant le réglage du volume de l'audio sur la base des informations de bruit ; et
un moyen configuré pour, après l'augmentation (302) du volume de l'audio sur la base du paramètre de réglage de volume, baisser le volume de l'audio au volume original de l'audio, quand il est détecté que l'amplitude du bruit ambiant a diminué.

4. Système selon la revendication 3, dans lequel l'unité d'acquisition d'informations (61) comprend :
une sous-unité de détection (610) configurée pour détecter les informations de bruit au moyen d'un capteur de bruit intégré ; ou
une sous-unité de réception (611) configurée pour recevoir les informations de bruit envoyées par un dispositif de capture de bruit.
